# EUROPEAN PATENT APPLICATION

(11) **EP 4 064 210 A1**
(43) Date of publication of application: **28.09.2022**
(21) Application number: 19953156.7
(22) Date of filing: 22.11.2019
(51) Int. Cl.: G06T 19/20, G06T 15/08, G06F 3/0484, G06T 19/00, G06Q 50/00, G06Q 30/06, G06Q 30/02

(54) **METHOD AND SERVER FOR CREATING AND UTILIZING VIRTUAL BUILDING**

(30) Priority: 19.11.2019 KR 20190149043
(71) Applicant: Dataking. Inc, Gyeonggi-do 14055 (KR)
(72) Inventor: PARK, Sun Kyou, Seoul 08350 (KR)
(74) Representative: Kurig, Thomas
(86) International application number: PCT/KR2019/016084
(87) International publication number: WO 2021/100923

(57) **Abstract**

A method for creating and utilizing a virtual building in a virtual space is provided. A method for creating and utilizing a virtual building, according to one aspect of the present invention, comprises the steps of: providing a voxel editing interface for a user to create a virtual building; creating a three-dimensional area for editing the exterior or the interior of the virtual building on the basis of a user input detected by the voxel editing interface; displaying a plurality of voxels on the basis of the user input detected in the three-dimensional area; creating at least one three-dimensional object on the basis of the plurality of voxels; and creating a virtual building including the at least one three-dimensional object.

## Description

### Technical Field

The present invention relates to a method and a server for generating and utilizing a virtual building in a virtual space, and more specifically, to a method and a server for enabling a user to easily generate a virtual building through a voxel editing interface.

### Background Art

Recently, with the development of network technology including the Internet, people perform a large amount of interchanges using a network, and perform various kinds of e-commerce. For instance, people promote themselves or obtain information about other people through media, such as homepages or blogs, and form personal relationships through functions like friend farming. Especially, because contents in which a virtual space and reality are combined away from time and space constraints are utilized in all areas of lives, the number of people who want to experience things difficult to experience in real life is increasing, as is the number of people who want to make new connections or to administer e-commerce in convergence type contents.

Contents in which a virtual space and reality are combined can induce the participation of users due to diversity and originality of virtual buildings applied to the contents. However, such virtual buildings have several disadvantages, in that only some experts can generate and manage virtual buildings and it may be difficult for general users to directly generate and manage a virtual building, such as an existing SNS application.

### Disclosure

### Technical Problem

Accordingly, the present invention has been made in view of the above-mentioned problems occurring in the related art, and it is an object of the present invention to provide a method and a server enabling a user to easily generate a virtual building through a voxel editing interface.

It is an object of the present invention to provide a method and a server enabling a user to increase the value of a virtual building generated by the user and perform a transaction.

The technical problems to be achieved through the present invention are not limited to those mentioned above, and other technical problems not mentioned herein will be obviously understood by one of ordinary skill in the art through the following description.

### Technical Solution

To accomplish the above-mentioned objects, according to an aspect of the present invention, there is provided a method for generating and utilizing a virtual building including the operations of: providing a voxel editing interface for a user to generate a virtual building; creating a three-dimensional area for editing the exterior or the interior of the virtual building based on a user input detected by the voxel editing interface; displaying a plurality of voxels based on the user input detected in the three-dimensional area; creating at least one three-dimensional object based on the plurality of voxels; and generating a virtual building including at least one three-dimensional object.

According to an aspect of the present invention, there is provided a server for generating and utilizing a virtual building which provides a voxel editing interface for a user to generate a virtual building, creates a three-dimensional area for editing the exterior or the interior of the virtual building based on a user input detected by the voxel editing interface, displays a plurality of voxels based on the user input detected in the three-dimensional area, creates at least one three-dimensional object based on the plurality of voxels, and generates a virtual building including at least one three-dimensional object.

Other specific details of the present invention are included in the detailed description and drawings.

### Advantageous Effects

According to the present invention, the present invention has the following various effects.

The present invention provides a voxel editing interface to a user so that the user can easily generate a virtual building in a virtual space.

Moreover, the present invention enables a user to utilize and transact a virtual building by enabling the user to generate the virtual building in the virtual space.

Furthermore, the present invention can induce a user to use contents in which a virtual space and reality are combined and can increase the immersion level of the user.

Additionally, the present invention can increase the security in value computation and transaction approval of the virtual building by using a blockchain network.

The advantages of the present disclosure are not limited to the above-mentioned advantages, and other advantages, which are not specifically mentioned herein, will be clearly understood by those skilled in the art from the following description.

### Description of Drawings

FIG. 1A is a block diagram illustrating a server and a user device according to an embodiment of the present invention.
FIG. 1B is a block diagram illustrating a system for generating and utilizing a virtual building according to an embodiment of the present invention.
FIG. 2 is a flow chart illustrating a method of transacting a virtual real estate and determining a value of the virtual real estate according to an embodiment of the present invention.
FIGS. 3 to 6 are views illustrating a method of transacting a virtual real estate and determining a value of the virtual real estate according to an embodiment of the present invention.
FIG. 7 is a flow chart illustrating a method of displaying a plurality of voxels according to an embodiment of the present invention.
FIG. 8 is a view illustrating a method of displaying a plurality of voxels according to an embodiment of the present invention.
FIG. 9 is a flow chart illustrating a method of generating a three-dimensional object according to an embodiment of the present invention.
FIGS. 10 and 11 are views illustrating a method of generating a three-dimensional object according to an embodiment of the present invention.

### Mode for Invention

Advantages and features of the present disclosure and methods accomplishing the advantages and features will become apparent from the following detailed description of exemplary embodiments with reference to the accompanying drawings. However, the present disclosure is not limited to exemplary embodiment disclosed herein but will be implemented in various forms. The exemplary embodiments are provided so that the present disclosure is completely disclosed, and a person of ordinary skilled in the art can fully understand the scope of the present disclosure. Therefore, the present disclosure will be defined only by the scope of the appended claims.

Terms used in the specification are used to describe specific embodiments of the present disclosure and are not intended to limit the scope of the present disclosure. In the specification, the terms of a singular form may include plural forms unless otherwise specified. It should be also understood that the terms of 'comprises' and/or 'comprising' in the specification are used to mean that there is no intent to exclude the existence or addition of other components besides components described in the specification. In the detailed description, the same reference numbers of the drawings refer to the same or equivalent parts of the present disclosure, and the term "and/or" is understood to include a combination of one or more of components described above. It will be understood that terms, such as "first" or "second" may be used in the specification to describe various components but are not restricted to the above terms. The terms may be used to discriminate one component from another component. Therefore, of course, the first component may be named as the second component within the scope of the present disclosure.

Unless otherwise defined, all terms (including technical and scientific terms) used herein have the same meaning as commonly understood by those skilled in the technical field to which the present disclosure pertains. It will be further understood that terms, such as those defined in commonly used dictionaries, should not be interpreted in an idealized or overly formal sense unless expressly so defined herein.

Terms, such as "below," "beneath," "lower," "above," "upper," and the like, which have spatially relative concepts, may be used to facilitate correlation between one component and other components, as illustrated in the drawings. Such spatially relative terms should be understood as terms including different directions of components during use or operation, in addition to the direction illustrated in the drawings. For example, if the components illustrated in the drawings are turned upside down, the components described as "below" or "beneath" may be placed "above" of other components. Thus, the exemplary term "under" may include all of the directions, "below" and "above". The components may be oriented in other directions, so that the spatially relative terms can be interpreted according to the orientation.

Hereinafter, preferred embodiments of the present disclosure will be described in detail with reference to the accompanying drawings.

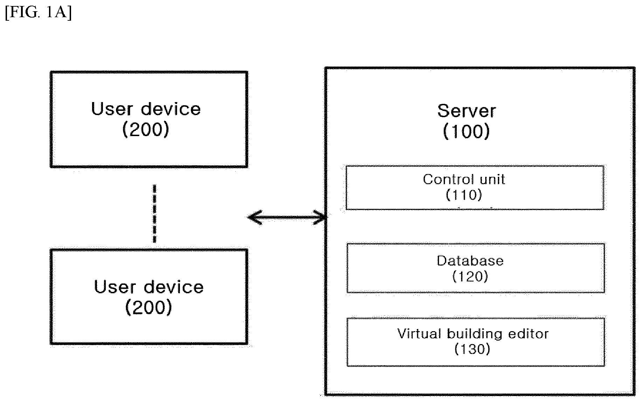

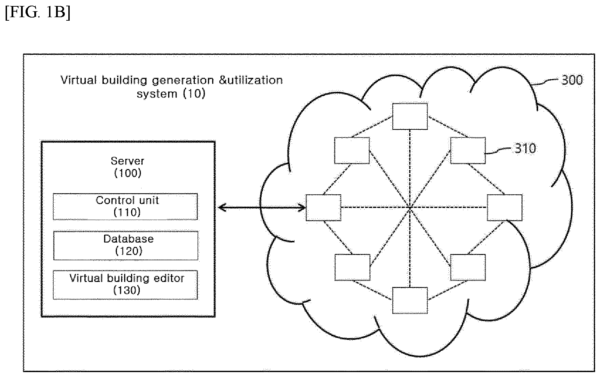

FIG. 1A is a block diagram illustrating a server and a user device according to an embodiment of the present invention, and FIG. 1B is a block diagram illustrating a system for generating and utilizing a virtual building according to an embodiment of the present invention.

Referring to FIG. 1A, a server 100 according to an embodiment of the present invention may be communicatively connected to a plurality of user devices 200, which are external devices, through a network. Here, the network may include a wireless network and a wired network. For example, the network may be a short-range communication network, e.g., Bluetooth, Wi-Fi Direct or Infrared Data Association (IrDA) or a long-range communication network, e.g., a cellular network, Internet, or a computer network, such as LAN or WAN.

In one embodiment, the server 100 provides a virtual interface to the user device 200 capable of creating, utilizing, and trading a virtual building through an intermediary platform, and may receive a mediation commission according to the utilization and transaction of the virtual building. Here, an intermediary platform may be a webpage or a dedicated application that a user can use, or may be a platform capable of providing a virtual interface. Here, the user is not limited to a user who lives in the country but may include users who live abroad and can connect to the intermediary platform.

In one embodiment, the virtual interface may mean not only an interface enabling a user to simply experience virtual reality but also an interface capable of providing a user with all kinds of contents in which reality and virtuality are fused. Therefore, the virtual interface may be one among a general mode showing a general webpage and a three-dimensional map and a virtual reality mode enabling a user to enter a map, such as a virtual reality.

In one embodiment, the virtual interface may include a virtual space in which reality and virtuality are fused. For instance, the virtual space may provide virtual real estate having an actual local name, for instance, Myeongdong, and an actual landmark, for instance, Myeongdong Catholic Cathedral. Here, the virtual real estate can be a concept including virtual land and a virtual building, and a user can be basically provided with a minimum of virtual land capable of generating a virtual building and additionally purchase virtual land. In addition, the user may directly generate a virtual building in the virtual land or purchase a preset virtual building. Here, money used for the purchase may be virtual money, for example, coins that can be traded in the server 100 and a blockchain network 300.

In one embodiment, the virtual interface may be set in a general mode and a virtual reality (VR) mode providing a three-dimensional virtual space. Here, the general mode can be a mode in which a user can access a virtual space in a three-dimensional shape, and the virtual reality mode can be a virtual reality experience mode enabling a user to experience the same situation as that the user actually enters the virtual space.

In one embodiment, the user may directly generate the interior and exterior of a virtual building through a voxel editing module provided by the server 100 and a voxel editing interface of the voxel editing module. Moreover, the user can create a store enabling the user to perform e-commerce in the generated virtual building and connect an external link to the store. Here, the store may include all kinds of e-commerce related stores that sell products and services. Here, the external link may be a link capable of ordering products or a link connected to an advertisement.

In one embodiment, the server 100 can determine a value of the virtual building based on at least one of user activity information and usage information of other users in the virtual building. Accordingly, the virtual building located in the virtual space of the present invention may have different values and sales prices. That is, the user can create a new added value by creating and operating the virtual building in the virtual space. Here, the user activity included in the user activity information may be generation of a virtual store in the virtual building, an addition of an external link in the virtual store, or provision of a content in the virtual building. The usage information of other users may include at least one among the number of visits to the virtual building, the feedback of the virtual building, the total sales of the virtual building, the function and the number of the external links connected to the virtual building, the number of contents provided by the virtual building, and the number of uses of the contents.

In one embodiment, the server 100 may include a control unit 110, a database 120, and a virtual building editor 130. The control unit 110 can manage the database 120 related to a user's membership information, information on the virtual real estate, the user activity information, usage information of other users, and transaction information of the virtual real estate, generally control various operations related to transaction and value determination of the virtual building, and generally control the intermediary platform providing the virtual interface. The database 120 can convert data related to the user's membership information, information on the virtual real estate, the user activity information, usage information of other users, and transaction information of the virtual real estate into big data, and store the big data. For instance, the virtual building editor 130 may be a voxel editing module or a voxel editing interface enabling a user to easily use the module.

Referring to FIG. 1B, the system 10 for generating and utilizing a virtual building according to an embodiment of the present invention may include a server 100 and a blockchain network 300, and the server 100 and the blockchain network 300 may be connected to each other. For example, the blockchain network 300 may include a plurality of nodes 310. When data related to building generation, building utilization, and building transaction and data related to usage information of other users are received from the server 100, the plurality of nodes 310 included in the blockchain network 300 may generate a block including the received data and password data corresponding to the received data, and add the generated block to a block chain. The added block chain can be shared between the plurality of nodes 310. Here, the block chain may mean a bundle of data related to building generation, building utilization, and building transaction and data related to usage information of other users. Therefore, the server 100 can manage generation, utilization, and transaction details of the virtual building through the blockchain network 300 and prevent falsification of usage information of other users.

According to an embodiment of the present invention, although not shown in the drawings, the server 100 can manage information when a user joins to be a member through an intermediary platform. The user's membership information may include name, address, phone number, virtual building generation history, virtual building utilization history, virtual real estate holding status, transaction history, virtual money retention status, and the like.

In one embodiment, the user device 200 may be at least one device that one user uses, and may be a device capable of using an intermediary platform providing a virtual interface and a voxel editing interface or a device in which the intermediary platform is installed.

In one embodiment, the user device 200 may include at least one among, for example, a smartphone, a tablet personal computer (PC), a mobile phone, a video phone, an e-book reader, a desktop PC, a laptop PC, a netbook computer, a workstation, a server, a personal digital assistant (PDA), a portable multimedia player (PMP), an MP3 player, a mobile medical device, a camera, and a wearable device.

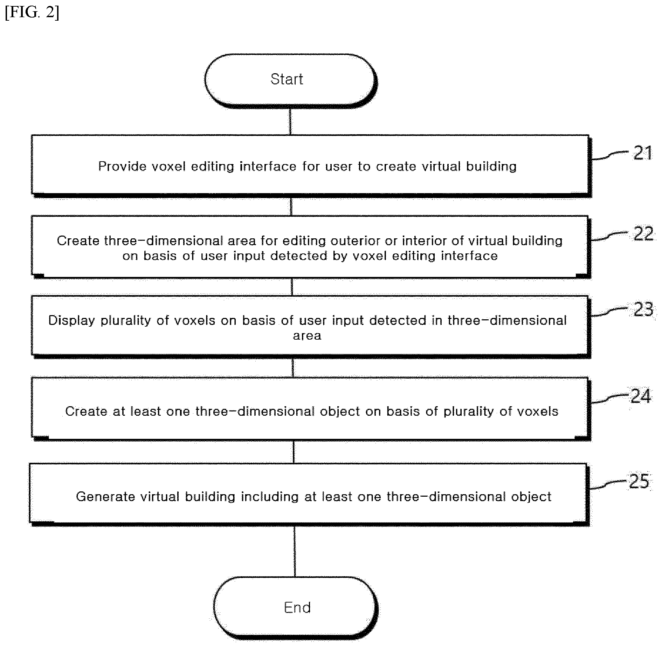

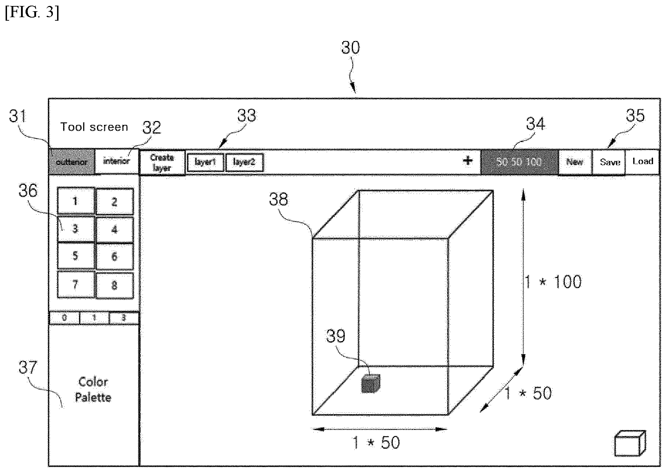

FIG. 2 is a flow chart illustrating a method of transacting a virtual real estate and determining a value of the virtual real estate according to an embodiment of the present invention, and FIGS. 3 to 6 are views illustrating a method of transacting a virtual real estate and determining a value of the virtual real estate according to an embodiment of the present invention. The operations of FIG. 2 may be performed by the server 100 of FIGS. 1A and IB.

Referring to FIGS. 2 to 6, in one embodiment, the server 100 may provide a voxel editing interface such that a user can generate a virtual building in a virtual space in the operation 21. The screen size, for instance, 1024^{∗}768, the voxel size, for instance, 1^{∗}1, the topography size, for instance, 50^{∗}50^{∗}100, and the topography unit, for example, 1 Hexa, of the voxel editing interface may be provided in various ways.

For example, as illustrated in FIG. 3, the voxel editing interface 30 may include an external selection menu 31 displaying the outside to edit the exterior of the virtual building, an internal selection menu 32 displaying the inside to edit the interior of the virtual building, a layer menu 33 generating a plurality of layers and selecting a layer among the plurality of layers generated, a menu 34 selecting the size of a three-dimensional area 38 displayed in voxels 39, a new file create/save/load menu 35, an editing function menu 36, and a color palette 37 enabling the user to select a color on the display screen. In addition, the voxel editing interface can provide an icon on the color palette 37 to change the palette layer so that various colors of the palette can be selected.

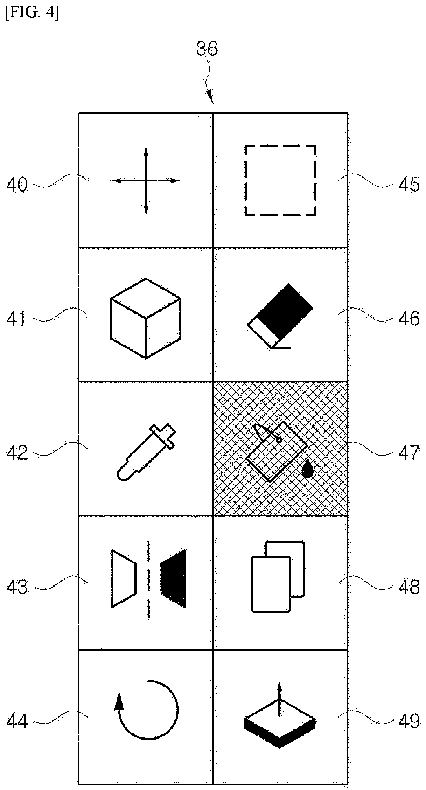

For example, the editing function menu 36 of the voxel editing interface, as illustrated in FIG. 4, may include a four-way arrow 40 (movement function: select and move), a color picker 42 (color selection function: select a color and apply the selected color at the time of box generation), a block 41 (block generation function : Form a rectangular shape at the time of mouse-over/ Create a cube when clicking/ Create a line box (horizontal or vertical) when clicking & dragging, Create a rectangular shape when moving at 90 degrees (movement from the horizontal direction to the vertical direction or from the vertical direction to the horizontal direction), an eraser 46 (block deleting function: Delete a selected block/ Remove in a line shape when clicking & dragging/ Delete in a rectangular shape when moving at 90 degrees), a brush 47 (paint function: Replace a color of the preset block), mirrors (x, y and z) 43 (mirror function: Mirrored in each axis when clicking a button after selecting each axis), a layer 49 (layer function: Create layers in one file so as to cope with a plurality of layers together), a back button 44 (returning function), a copy 48 (copy function: Copying and tipping a block having the same selected color), a group selection 45 (same color selection: Function capable of selecting in cubic, column, row, and the same color groups, and functions of movement, copy, mirror, and layer copy).

In addition, the voxel editing interface may provide an icon having a camera switching function, an icon capable of rotating a three-dimensional area or a plurality of voxels, an orientation icon capable of viewing the front/rear/left/right/top/bottom, and a function of enlarging and reducing according to a mouse scroll. Of course, the voxel editing interface may also provide icons having functions of different types to allow a user to easily generate a virtual building.

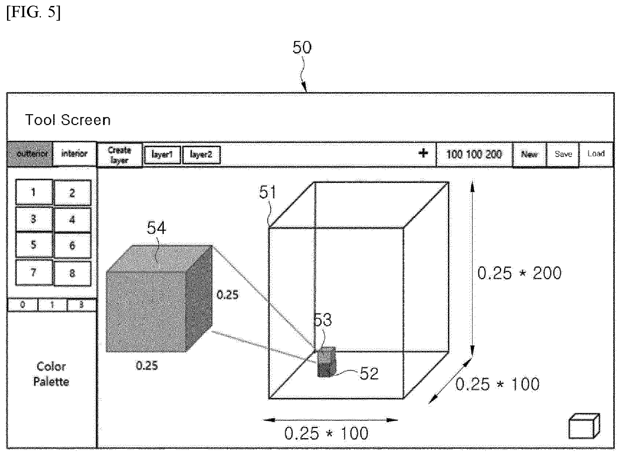

In one embodiment, the server 100 may generate a three-dimensional area for editing the exterior or interior of the virtual building based on the user input detected at the voxel editing interface in the operation 22. For example, as illustrated in FIG. 5, the virtual building editor 130 can display a three-dimensional area 51 of a 100^{∗}100^{∗}200 size on the voxel editing interface 50 based on the user input.

In one embodiment, the server 100 can display a plurality of voxels based on the user input detected in the three-dimensional area in the operation 23. That is, the user can add only one voxel while clicking the block generation icon or add voxels with various sizes through drag input. For example, as illustrated in FIG. 5, the virtual building editor 130 may display additional voxels 53 adjacent to the existing voxel 52 based on user input, e.g., click or drag, and can enlarge and display 54 additional voxels 53 to be clicked or dragged now.

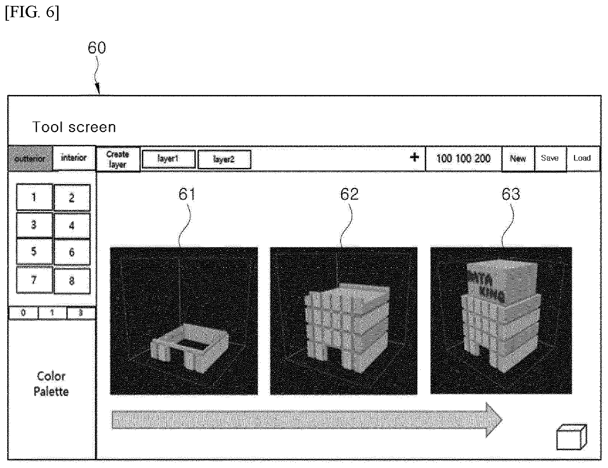

In one embodiment, the server 100 can generate at least one 3D object based on a plurality of voxels in the operation 24. For example, the user can generate a 3D object, such as a single-story building 61 and a multi-story building 62, included in the voxel editing interface 60 illustrated in FIG. 6 while generating the plurality of voxels.

In one embodiment, the server 100 can generate a virtual building that includes at least one 3D object in the operation 25. For example, the virtual building editor 130 can generate a virtual building 63 through a user's continuous input as illustrated in FIG. 6. In order to explain the operation of generating the virtual building 63 may be respectively displayed on separate layers through the layer function.

As described above, the user can easily generate a desired virtual building by adding voxels in a three-dimensional area while selecting a menu or an icon.

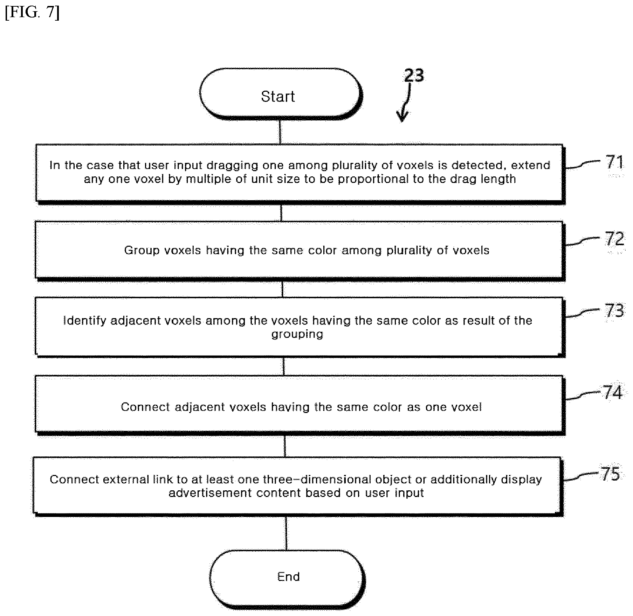

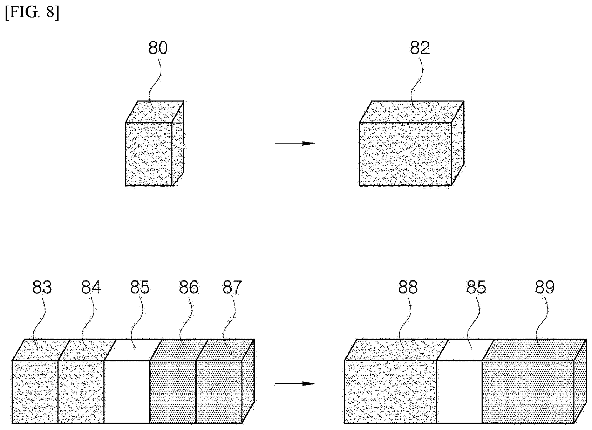

FIG. 7 is a flow chart illustrating a method of displaying a plurality of voxels according to an embodiment of the present invention. FIG. 8 is a view illustrating a method of displaying a plurality of voxels according to an embodiment of the present invention. The operations of FIG. 7 may be performed by the server 100 of FIGS. 1A and IB. The operations of FIG. 7 are operations specifying the operation 23 of displaying a plurality of voxels. Here, the operation sequence of the operations of FIG. 7 is not limited to the order of FIG. 7, and the operation order may be changed.

Referring to FIGS. 7 and 8, in one embodiment, the server 100 may extend any one voxel by a multiple of a unit size to be proportional to a drag length when a user input for dragging one among the plurality of voxels is detected in the operation 71. For example, as illustrated in FIG. 8A, when detecting the user's drag input in the voxel 80, the virtual building editor 130 may generate the voxel 82 extended by two times the unit size of the voxel 80. Of course, the size of the voxel can be changed in various ways.

In one embodiment, the server 100 may group the plurality of voxels by voxels having the same color in the operation 72. For example, as illustrated in FIG. 8B, the virtual building editor 130 groups the voxel 83 and the voxel 84 into the same group and groups the voxel 86 and the voxel 87 into the same group.

In one embodiment, the server 100 may identify adjacent voxels among the voxels with the same color as the result of grouping in the operation 73.

In one embodiment, the server 100 may connect adjacent voxels having the same color as one voxel in the operation 74. For instance, as illustrated in FIG. 8B, the virtual building editor 130 may connect the voxel 83 and the voxel 84, which are in the same group, as one voxel 88, and may connect the voxel 86 and the voxel 87, which are in the same group, as one voxel 89.

In one embodiment, the server 100 may connect an external link to at least one three-dimensional object or additionally display advertisement content based on the user input in the operation 75. For example, the virtual building editor 130 may display an advertisement phrase, "Data Making Experience", on a portion of the virtual building 63 generated as illustrated in FIG. 6.

Accordingly, the user can reduce time to easily generate a virtual building using voxels through the voxel editing interface.

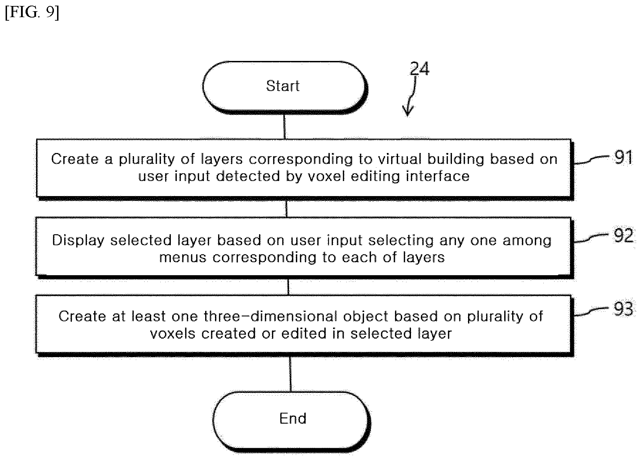

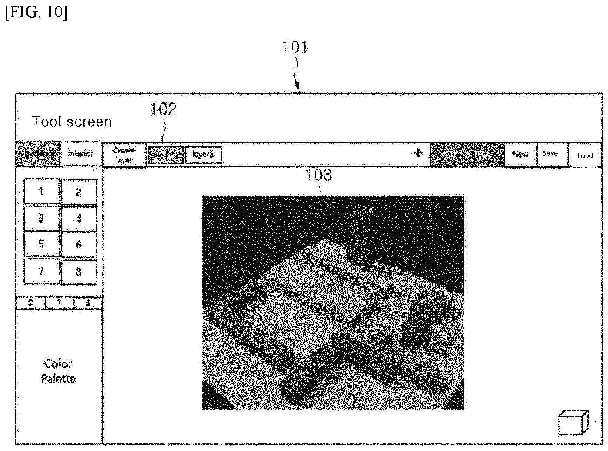

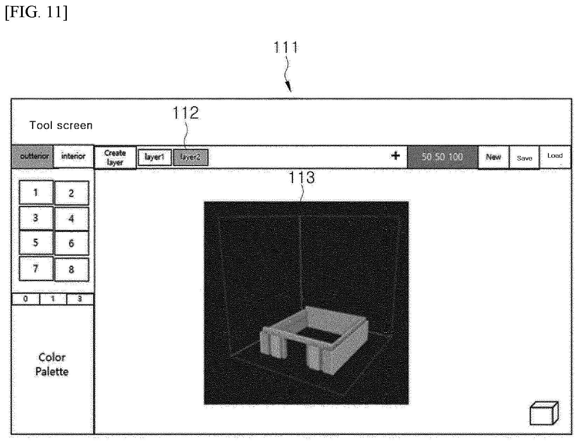

FIG. 9 is a flow chart illustrating a method of generating a three-dimensional object according to an embodiment of the present invention. FIGS. 10 and 11 are views illustrating a method of generating a three-dimensional object according to an embodiment of the present invention. The operations of FIG. 9 may be performed by the server 100 of FIGS. 1A and IB. The operations of FIG. 9 are operations embodying the operation 24 of displaying the plurality of voxels.

Referring to FIGS. 9 to 11, in one embodiment, the server 100 may generate a plurality of layers corresponding to the virtual building based on the user input detected from the voxel editing interface in the operation 91. For example, the virtual building editor 130 may generate a first layer and a second layer as illustrated in FIGS. 10 and 11 based on the user input selecting the layer menu, e.g., a create layer.

In one embodiment, the server 100 may display a selected layer based on the user input selecting any one of the menus corresponding to each of the plurality of layers in the operation 92. For instance, the virtual building editor 130 may display the three-dimensional area 103 of the first layer in the voxel editing interface 101 based on the user input selecting the first layer 101, and may display the three-dimensional area 113 of the first layer in the voxel editing interface 111 based on the user input selecting the second layer 112.

In one embodiment, the server 100 may generate at least one three-dimensional object based on the plurality of voxels generated or edited in the layer selected in the operation 93.

As described above, the present invention provides the function of easily changing the plurality of layers so as to enable a user to simultaneously perform various tasks in one file and to increase efficiency of generating a virtual building.

Although not shown in the drawings, the server 100 may determine the value of the virtual building based on the user activity information sensed by the generated virtual building. For example, the user activity information may include at least one among generation of a virtual space allowing users to interchange with acquaintances in the virtual building, generation of a virtual store, addition of an external link in the virtual store, and provision of contents in the virtual building. Here, the value of the virtual building may be a value convertible into virtual money computable in the intermediary platform of the present invention, and may be a value determined in comprehensive consideration of the user's activities and other users' usages of the virtual building. That is, the value of the virtual building can be increased when the user arranges popular stores, spaces for exchange, or popular contents in the virtual building so that other users can frequently visit the virtual building. Of course, besides the above, the value of the virtual building can be determined in consideration of the scale of the virtual building, a distance between the virtual building and a land mark.

Although not shown in the drawings, the server 100 may mediate transaction of the virtual building based on a renewed value of the virtual building. For example, the server 100 may obtain a mediation commission as virtual money in a transaction mediation process. Specifically, the server 100 may receive a sales request of the virtual building from a user of the virtual building through the virtual interface, and provide the value and the sales amount of the virtual building to other users through the virtual interface. For instance, the server 100 may directly publish the sales items on the virtual building of the virtual interface or may notify the sales items through a separate layer or a bulletin board. In addition, the server 100 may receive a purchase request of the virtual building from any one of users, and may approve transaction of the virtual building when the sales request and the purchase request satisfy the transaction requirements. For example, the satisfaction of transaction requirements may be a case where virtual money corresponding to a sales amount is paid. Moreover, the server 100 may store the data associated with the approved transaction in the database 120 of the server 100 and the node 310 of the blockchain network 300. Accordingly, a real estate ledger can be safely stored.

According to an aspect of the present invention, the method for generating and utilizing a virtual building may include the operations of: providing a voxel editing interface for a user to generate a virtual building; creating a three-dimensional area for editing the exterior or the interior of the virtual building based on a user input detected by the voxel editing interface; displaying a plurality of voxels based on the user input detected in the three-dimensional area; creating at least one three-dimensional object based on the plurality of voxels; and generating a virtual building including at least one three-dimensional object.

According to various embodiments, the method for generating and utilizing a virtual building may further include the operations of: creating a plurality of layers corresponding to the virtual building based on the user input detected by the voxel editing interface; displaying a selected layer based on the user input selecting any one among the menus corresponding to each of the layers; and creating the at least one three-dimensional object based on the plurality of voxels created or edited in the selected layer.

According to various embodiments, in the case that a user input dragging one among the plurality of voxels is detected, the method for generating and utilizing a virtual building may further include the operation of: extending any one voxel by a multiple of a unit size to be proportional to the drag length.

According to various embodiments, the method for generating and utilizing a virtual building may further include the operations of: grouping voxels having the same color among the plurality of voxels; identifying adjacent voxels among the voxels having the same color as the result of the grouping; and connecting the adjacent voxels having the same color as one voxel.

According to various embodiments, the method for generating and utilizing a virtual building may further include the operation of: connecting an external link to the at least one three-dimensional object or additionally displaying an advertisement content based on the user input.

According to various embodiments, the method for generating and utilizing a virtual building may further include the operations of: determining a value of the virtual building based on the user activity information sensed in the generated virtual building; and mediating transaction of the virtual building based on the determined value of the virtual building.

According to an aspect of the present invention, the server for generating and utilizing a virtual building may provide a voxel editing interface for a user to generate a virtual building, create a three-dimensional area for editing the exterior or the interior of the virtual building based on a user input detected by the voxel editing interface, display a plurality of voxels based on the user input detected in the three-dimensional area, create at least one three-dimensional object based on the plurality of voxels, and generate a virtual building including at least one three-dimensional object.

According to various embodiments, the server for generating and utilizing a virtual building may create a plurality of layers corresponding to the virtual building based on the user input detected by the voxel editing interface, display a selected layer based on the user input selecting any one among the menus corresponding to each of the layers, and create the at least one three-dimensional object based on the plurality of voxels created or edited in the selected layer.

According to various embodiments, in the case that a user input dragging one among the plurality of voxels is detected, the server for generating and utilizing a virtual building may extend any one voxel by a multiple of a unit size to be proportional to the drag length, group voxels having the same color among the plurality of voxels, identify adjacent voxels among the voxels having the same color as the result of the grouping, and connect the adjacent voxels having the same color as one voxel.

According to various embodiments, a program for generating and utilizing a virtual building can be combined with a computer, which is hardware, to be stored in a medium to execute the virtual building generation and utilization method.

The method or algorithm described in relation to the embodiments of the present disclosure can be directly embodied in hardware, can be embodied in a software module executed by hardware, or can be embodied by combination thereof. The software module can reside in a random access memory (RAM), a read-only memory (ROM), an erasable programmable read-only memory (EPROM), an electrically erasable programmable read-only memory (EEPROM), a flash memory, a hard disk, a detachable disk, a CD-ROM, or a medium readable by a computer, well-known in the technical field to which the present disclosure belongs.

The above description is only exemplary, and it will be understood by those skilled in the art that the disclosure may be embodied in other concrete forms without changing the technological scope and essential features. Therefore, the above-described embodiments should be considered only as examples in all aspects and not for purposes of limitation.

## Claims

1. A method for generating and utilizing a virtual building comprising the operations of:
providing a voxel editing interface for a user to generate a virtual building;
creating a three-dimensional area for editing the exterior or the interior of the virtual building based on a user input detected by the voxel editing interface;
displaying a plurality of voxels based on the user input detected in the three-dimensional area;
creating at least one three-dimensional object based on the plurality of voxels; and
generating a virtual building including at least one three-dimensional object.

2. The method according to claim 1, further comprising the operations of:
creating a plurality of layers corresponding to the virtual building based on the user input detected by the voxel editing interface;
displaying a selected layer based on the user input selecting any one among the menus corresponding to each of the layers; and
creating the at least one three-dimensional object based on the plurality of voxels created or edited in the selected layer.

3. The method according to claim 1, in the case that a user input dragging one among the plurality of voxels is detected, further comprising the operation of:
extending any one voxel by a multiple of a unit size to be proportional to the drag length.

4. The method according to claim 1, further comprising the operations of:
grouping voxels having the same color among the plurality of voxels;
identifying adjacent voxels among the voxels having the same color as the result of the grouping; and
connecting the adjacent voxels having the same color as one voxel.

5. The method according to claim 1, further comprising the operation of:
connecting an external link to the at least one three-dimensional object or additionally displaying an advertisement content based on the user input.

6. The method according to claim 1, further comprising the operations of:
determining a value of the virtual building based on the user activity information sensed in the generated virtual building; and
mediating transaction of the virtual building based on the determined value of the virtual building.

7. A server for generating and utilizing a virtual building, wherein the server
provides a voxel editing interface for a user to generate a virtual building,
creates a three-dimensional area for editing the exterior or the interior of the virtual building based on a user input detected by the voxel editing interface,
displays a plurality of voxels based on the user input detected in the three-dimensional area,
creates at least one three-dimensional object based on the plurality of voxels, and
generates a virtual building including at least one three-dimensional object.

8. The server according to claim 7, wherein the server
creates a plurality of layers corresponding to the virtual building based on the user input detected by the voxel editing interface,
displays a selected layer based on the user input selecting any one among the menus corresponding to each of the layers, and
creates the at least one three-dimensional object based on the plurality of voxels created or edited in the selected layer.

9. The server according to claim 7, wherein in the case that a user input dragging one among the plurality of voxels is detected, the server
extends any one voxel by a multiple of a unit size to be proportional to the drag length,
groups voxels having the same color among the plurality of voxels,
identifies adjacent voxels among the voxels having the same color as the result of the grouping, and
connects the adjacent voxels having the same color as one voxel.

10. A program for generating and utilizing a virtual building, wherein the program is combined with a computer, which is hardware, and is stored in a medium to execute the method according to any one of claims 1 to 6.
